# EUROPÄISCHE PATENTSCHRIFT

(11) **EP 2 804 008 B1**
(45) Veröffentlichungstag und Bekanntmachung des Hinweises auf die Patenterteilung: **04.03.2015**
(21) Anmeldenummer: 13167804.7
(22) Anmeldetag: 15.05.2013
(51) Int. Cl.: G01R 31/3185, G01V 8/00

(54) **Sensor zur Überwachung und Verfahren zur Fehleraufdeckung**
Sensor for monitoring and a method for error detection
Capteur de surveillance et procédé de détection d'erreurs

(43) Veröffentlichungstag der Anmeldung: 19.11.2014
(73) Patentinhaber: SICK AG, 79183 Waldkirch (DE)
(72) Erfinder: Zwölfer, Ulrich, 79183 Waldkirch (DE); Müller, Lars, 79108 Freiburg (DE); Neubauer, Dr., Matthias, 79106 Freiburg (DE)
(74) Vertreter: Hehl, Ulrich

(56) Entgegenhaltungen:
- US-A1- 2007 011 539
- US-A1- 2011 068 820
- REN Y J ET AL: "The Application of Virtex-II Pro FPGA in High-Speed Image Processing Technology of Robot Vision Sensor", JOURNAL OF PHYSICS: CONFERENCE SERIES, INSTITUTE OF PHYSICS PUBLISHING, BRISTOL, GB, Bd. 48, Nr. 1, 1. Oktober 2006 (2006-10-01), Seiten 373-378, XP020110748, ISSN: 1742-6596, DOI: 10.1088/1742-6596/48/1/070
- ALESSANDRO CILARDO ET AL: "Virtual Scan Chains for Online Testing of FPGA-based Embedded Systems", DIGITAL SYSTEM DESIGN ARCHITECTURES, METHODS AND TOOLS, 2008. DSD '08. 11TH EUROMICRO CONFERENCE ON, IEEE, PISCATAWAY, NJ, USA, 3. September 2008 (2008-09-03), Seiten 360-366, XP031509374, ISBN: 978-0-7695-3277-6

## Beschreibung

Die Erfindung betrifft einen Sensor zur Überwachung eines Überwachungsbereichs mit einer sicheren Auswertungseinheit und ein Verfahren zur Fehleraufdeckung in einer Auswertungseinheit nach dem Oberbegriff von Anspruch 1 beziehungsweise 15.

Zur Erfassung von Informationen aus einem Überwachungsbereich sind diverse Sensorprinzipien bekannt. Eine große Sensorfamilie bilden die optoelektronischen Sensoren, die Licht zur Gewinnung solcher Informationen verwenden. Es werden aber auch andere Wellenlängen, etwa in Radar- oder Mikrowellensensoren, oder andere physikalische Wechselwirkungen genutzt, wie in kapazitiven, induktiven oder auf Ultraschall basierenden Sensoren.

In vielen Anwendungen ist die zuverlässige Funktion des eingesetzten Sensors von essentieller Bedeutung. Das gilt ganz besonders in der Sicherheitstechnik, in der die Sensoren zum Schutz von Personen dienen. Eine typische sicherheitstechnische Anwendung ist die Absicherung einer gefährlichen Maschine, wie etwa einer Presse oder eines Roboters, wo bei Eingriff eines Körperteils in einen Gefahrenbereich um die Maschine herum eine Absicherung erfolgt. Dies kann je nach Situation die Abschaltung der Maschine oder das Verbringen in einen sicheren Zustand sein.

Sicherheitsanforderungen an die Zuverlässigkeit von in der Sicherheitstechnik eingesetzten Sensoren sind standardisiert, beispielsweise in der Norm EN13849 für Maschinensicherheit oder der Gerätenorm EN61496 für berührungslos wirkende Schutzeinrichtungen (BWS). Eine vergleichbare Norm für sichere Kameras befindet sich in Vorbereitung. Zur Erfüllung solcher Sicherheitsnormen sind eine Reihe von Maßnahmen zu treffen, wie beispielsweise die sichere Erfassung der Sensordaten und die sichere elektronische Auswertung.

Die Funktionsüberprüfung der Auswertung wird natürlich mit wachsender Komplexität der Auswertung immer schwieriger. Ein wichtiger Indikator für die Komplexität ist die zu verarbeitende Informationsmenge, die beispielsweise bei den Bilddaten einer Kamera unvergleichlich viel größer ist als bei einem einfachen Intensitätspegel einer Lichtschranke.

Eine weitere Komplexitätsstufe kommt bei 3D-Kameras hinzu, die auch eine Tiefeninformation aufnehmen und somit dreidimensionale Bilddaten erzeugen, die auch als Entfernungsbild oder Tiefenkarte bezeichnet werden. Die zusätzliche Entfernungsdimension lässt sich in einer Vielzahl von Anwendungen nutzen, um mehr Informationen über Objekte in der von der Kamera erfassten Szenerie zu gewinnen. Die dreidimensionalen Bilddaten jedoch müssen erst durch entsprechende Auswertungen gewonnen werden.

Bei stereoskopischen Systemen werden dazu jeweils mindestens zwei Aufnahmen aus unterschiedlicher Perspektive erzeugt. In den überlappenden Bildbereichen werden gleiche Strukturen identifiziert und aus der Disparität und den optischen Parametern des Kamerasystems mittels Triangulation Entfernungen und somit das dreidimensionale Bild beziehungsweise die Tiefenkarte berechnet. Andere Triangulationssysteme verwenden nur eine Kamera und werten die Veränderungen des projizierten Musters durch Objekte in verschiedenen Entfernungen aus. Dazu wird dem System das Beleuchtungsmuster eingelernt und so eine Erwartungshaltung für die Bilddaten bei verschiedenen Objektentfernungen und -strukturen generiert. Eine Möglichkeit besteht darin, das Beleuchtungsmuster auf Objekten, insbesondere einer Fläche, in verschiedenen Entfernungen als Referenzbild einzulernen.

Ein weiteres bekanntes 3D-Verfahren basiert auf einem Lichtlaufzeitverfahren, in dem die Lichtlaufzeit zwischen Aussenden des Lichts einer aktiven Beleuchtung und dessen Empfang pixelaufgelöst bestimmen, etwa mittels PMD (Photonmischdetektion). Mit einem Lichtlaufzeitverfahren arbeiten auch Laserscanner, die im Gegensatz zu einer Kamera ein Bild nicht auf einmal erfassen, sondern die Szenerie mit Hilfe eines periodisch abgelenkten Lichtstrahls abtasten.

Herkömmlich wird die sichere Auswertung durch Maßnahmen wie Mehrkanaligkeit oder spezielle Funktionstests gewährleistet. Mehrkanaligkeit bedeutet Redundanz in der Hardware und damit eine deutliche Erhöhung der Herstellkosten und der aufgenommenen Leistung. Funktionstests müssen aufwändig für den konkreten Sensor entworfen und implementiert werden, und sie decken nur diejenigen Szenarien ab, die während der Spezifikation berücksichtigt wurden. Weitere herkömmliche Methoden zur Reduzierung von Fehlern sind FMEA (Failure Mode and Effects Analysis) auf Modulebene oder die Einführung von speziellen, in Handarbeit und aufwändig zu generierenden Schaltungsteilen für Tests.

Für die Auswertung großer Datenmengen werden in Sensoren zunehmend rekonfigurierbare integrierte Schaltungen wie beispielsweise FPGAs (Field Programmable Gate Array) eingesetzt. Die Halbleiterstrukturen für derartige Bausteine liegt schon heute bei Gatelängen von 25 nm, dies wird sich voraussichtlich in den nächsten fünf Jahren auf 13 nm und einige Jahre später möglicherweise nochmals auf 6 nm praktisch halbieren. Entsprechend nehmen die Komplexitäten des Designs einen Umfang ein, deren Beherrschung nicht nur für das Design selbst, sondern auch für die Gewährleistung der Zuverlässigkeit eine zunehmende Herausforderung darstellt.

FPGAs werden nach deren Produktion einmalig einem Test unterzogen, der sowohl statische als auch dynamische Parameter testet. Dafür sind entsprechende Funktionen in die Gesamtschaltung integriert und für den Produktionstest zugänglich. Damit lässt sich aber bestenfalls gewährleisten, dass das FPGA anfänglich keinen Hardwareschaden aufweist. Ein In-Betrieb-Test ist dabei nicht vorgesehen und wird auch nicht unterstützt. Lediglich sogenannte SEU-Checker (Single-Event-Upset) für die Überprüfung der Konfiguration sehen manche Hersteller vor. Das FPGA selbst bietet also mit herkömmlicher Technologie keine Möglichkeit, eine sichere Fehlererkennung der Auswertung zu gewährleisten.

Aus der US 5,841,790 ist ein Test eines ASICs einer Adapterkarte bekannt, indem ein FPGA zufällige Testmuster in ein aus Logikelementen des ASICs gebildetes Schieberegister einführt. Dieser Test betrifft folglich das ASIC und nicht das FPGA. Außerdem wird der Test vorab durchgeführt und nicht während des Betriebs, denn im Anschluss an den Test wird das FPGA für den normalen Betrieb der Adapterkarte rekonfiguriert. Damit lässt sich bestenfalls ein spezifikationsgemäßer Anfangszustand, nicht aber ein sicherer Betrieb etwa im Sinne der oben genannten Normen erreichen.

Die EP 1 130 410 A2 erzeugt sogenannte Abtastpfade für eine gegebene Logik auf einem FPGA in einer Hardwarebeschreibungssprache. Dies ist ein Beispiel für die genannten Produktionstests, um anfängliche Hardwareschäden auszuschließen. Die Möglichkeit, Fehler während des Betriebs aufzudecken, wird in EP 1 130 410 A2 nicht erwähnt, so dass auch auf diese Weise erneut kein sicherer Betrieb etwa im Sinne der oben genannten Normen erreicht wird.

Aus der US 2007/011539 A1 ist eine Selbstteststruktur für Logikelemente eines FPGAs bekannt. Darin werden Logikelemente während eines Resets zum Testen zu einem vollständigen Pfad verbunden.

Der Artikel von V.J.Ren et al., "The Application of Virtex-II Pro FPGA in High-Speed Image Processing Technology of Robot Vision Sensor", Journal of Physics: Conference Series 48 (2006), Seiten 373-378 befasst sich mit einer Roboterkamera, die zur Bildverarbeitung ein FPGA einsetzt.

Es ist daher Aufgabe der Erfindung, während des Betriebs eines Sensors zuverlässig mögliche Fehler in dessen Auswertungsstrukturen aufzudecken.

Diese Aufgabe wird durch einen Sensor zur Überwachung eines Überwachungsbereichs mit einer sicheren Auswertungseinheit und ein Verfahren zur Fehleraufdeckung in einer Auswertungseinheit nach Anspruch 1 beziehungsweise 15 gelöst. Dabei geht die Erfindung von dem Grundgedanken aus, anstelle von funktionalen Tests direkt die Funktion der Hardware der sicheren Auswertungseinheit zu testen. Sicher bedeutet in diesem Zusammenhang, dass die Verlässlichkeit der Auswertung geprüft wird, beispielsweise im Sinne der einleitend genanten Normen. Die sichere Auswertung erfolgt zumindest teilweise in einem FPGA, wobei dieser Begriff weit als applikationsspezifische oder rekonfigurierbare integrierte Schaltung zu verstehen sein soll und beispielsweise auch künftige Weiterentwicklungen von FPGAs umfasst, die dann möglicherweise einen anderen Namen tragen werden. Mit Hilfe einer Prüfeinheit werden Fehler der Auswertungseinheit, insbesondere des FPGA, wie beispielsweise zufällige Hardwarefehler aufgedeckt. Zu solchen Fehlern zählen beispielsweise Stuck-At-Fehler, wobei dies hier vornehmlich im Sinne eines logischen Fehlermodells zu verstehen ist und nicht physikalisch, d. h. beispielsweise, dass ein Logikbereich aufgrund eines Fehlers trotz veränderter Eingänge stets zu denselben Ergebnissen an seinen Ausgängen kommt und dadurch die spezifikationsgemäße Funktion nicht mehr gewährleistet ist.

Ein typisches Logikelement ist dabei ein Flipflop mit den beiden binären Logikzuständen Hi und Low beziehungsweise Eins und Null sowie einem Ein- und Ausgang. Weitere Beispiele für Logikelemente sind allgemeine Speicherelemente oder Latches.

Die Fehleraufdeckung erfolgt, indem das FPGA in einen Testmodus geschaltet werden kann, in dem Logikelemente des FPGA eine oder mehrere Testketten bilden. Jedes Logikelement einer Testkette, mit Ausnahme des ersten und letzten Logikelements der Testkette, ist dabei mit jeweils einem Eingang mit einem Vorgänger und mit einem Ausgang mit einem Nachfolger seriell verbunden. In den Strukturen des FPGA können vorzugsweise Logikelemente, die durch Testketten verbunden werden, und kombinatorische Schaltungsteile unterschieden werden, die mit bestimmten Logikelementen der Testkette verbunden sind. Somit werden die Strukturen des FPGA entweder direkt durch die Testkette verbunden oder als dazwischenliegende kombinatorische Schaltungsteile getestet. Die Fehleraufdeckung erfolgt nicht nur wie herkömmlich einmal anfänglich nach Abschluss des Produktionsprozesses, sondern die Prüfeinheit schaltet regelmäßig während des laufenden Betriebs in den Testmodus um, damit auch im Laufe der Lebensdauer auftretende Fehler erkannt werden.

Die Erfindung hat den Vorteil, dass ein zuverlässiger In-Betrieb-Test der Auswertungsstrukturen möglich wird, der im Gegensatz zu funktionalen Tests gänzlich unabhängig von der tatsächlichen Funktion und daher generisch implementierbar ist. Es wird ermöglicht, einen Logikfluss beziehungsweise Entwicklungs- oder Entwurfsablauf zu generieren, der automatisiert Testketten beispielsweise auf RTL- (Register Transfer Level) oder Netzlistenbasis in das Design integriert. Ebenso können die erforderlichen Testmuster automatisch erzeugt werden. Damit sind beispielsweise Testabdeckungen von 90% und mehr bei Stuck-at-Fehlern ohne Weiteres erreichbar. Somit kann eine weitgehend automatisierte und kosteneffiziente Implementierung eines In-Betrieb-Tests einer sicheren Auswertungseinheit und insbesondere von deren FPGA realisiert werden. Der In-Betrieb-Test kann einkanalig bleiben, wobei aber umgekehrt auch eine mehrkanalige Struktur zur Erhöhung der Sicherheit vorteilhaft gemäß der Erfindung überprüft werden kann.

Der Sensor ist bevorzugt ein optoelektronischer Sensor. Das Sensorelement umfasst dann einen Lichtempfänger, beispielsweise eine Photodiode oder einen Bildsensor, und die Überwachungsinformation ist dessen Empfangssignal, wie ein Pegelsignal oder Bilddaten.

Die Logikelemente bilden in der Testkette bevorzugt ein Schieberegister, in dem auf einen Takt hin ein Logikelement seinen Logikzustand an seinen Nachfolger in der Testkette weitergibt. Damit kann ein Testmuster zyklisch in die Testkette eingetaktet werden, indem jeweils mit einem Takt ein Bit des Testmusters auf den Eingang der Testkette gelegt wird. Nach einer Anzahl Takten entsprechend der Länge der Testkette ist dann das Testmuster in das Schieberegister geladen und jedes Logikelement in einem durch das Testmuster definierten Logikzustand.

Die Testkette weist bevorzugt einen Testmustereingang für die Eingabe eines Logikzustands an das erste Element der Testkette, einen Testmusterausgang für die Ausgabe eines Logikzustands von dem letzten Element der Testkette, einen Testtakteingang sowie einen Testmoduseingang zum Umschalten zwischen Testmodus und eigentlichem Betrieb auf. Über diese vier Ein- und Ausgänge können die relevanten Operationen der Testkette ausgeführt werden.

Die Logikelemente weisen bevorzugt ein Multiplexelement auf, das im Testmodus den Eingang des Logikelements mit dem Vorgänger in der Testkette verbindet. Das Multiplexelement bildet also einen Schalter, mit dem ein Logikelement wahlweise innerhalb des Testmodus' zum Teil der Testkette und ansonsten zum Teil des für die eigentliche Auswertung vorgesehenen Logikflusses wird.

Die Prüfeinheit ist bevorzugt dafür ausgebildet, für eine Überprüfung der Funktion in einem ersten Schritt die Logikelemente in den Testmodus umzuschalten, dadurch zu der mindestens einen Testkette zu verbinden und einen Testvektor in die Testkette zu laden, in einem zweiten Schritt den Testmodus auszuschalten und mindestens einen Arbeitstakt des FPGA auszuführen, und in einem dritten Schritt die Logikelemente nochmals in den Testmodus umzuschalten und den durch den mindestens einen Arbeitstakt veränderten Testvektor aus der Testkette zu lesen. So werden zunächst im ersten Schritt die an der Testkette beteiligten Logikelemente in den von dem Testvektor definierten Zustand gebracht. Dies ermöglicht es, im zweiten Schritt direkt die tatsächliche Logik des Betriebs zu testen, indem mindestens ein Verarbeitungsschritt mit den durch den Testvektor vorgegebenen Logikzuständen ausgeführt wird. Im dritten Schritt wird der derart verarbeitete Testvektor wieder aus der Testkette gelesen und kann mit einem erwarteten verarbeiteten Testvektor verglichen werden, um Fehler aufzudecken. Da mit einem Testvektor nur ein Teil des möglichen Logikflusses getestet werden kann, wird die Überprüfung üblicherweise mit verschiedenen Testvektoren wiederholt, um die Fehleraufdeckungsrate zu verbessern.

Die Prüfeinheit ist bevorzugt dafür ausgebildet, während des Lesens des veränderten Testvektors bereits einen neuen Testvektor in die Testkette zu laden. Das simultane Laden und Auslesen erfolgt vorzugsweise im gleichen Takt. Es werden also mit jedem Takt zugleich neue Bits des nächsten Testvektors von vorne in die Testkette eingeschoben und die verarbeiteten Bits des aktuellen Testvektors am Ende der Testkette ausgeschleust. Dadurch überlappen sich der erste und dritte Schritt vollständig, und das Testen wird um einen Faktor zwei beschleunigt, da man die Dauer des mindestens einen Arbeitstakts des zweiten Schritts bei üblichen Längen der Testketten von zumindest einigen hundert oder tausend Logikelementen vernachlässigen kann.

Die Logikelemente sind in dem Testmodus bevorzugt zu mehreren Testketten verbunden, und die Prüfeinheit ist dafür ausgebildet, die mehreren Testketten parallel zu überprüfen. Es werden also mehrere Testvektoren gleichzeitig in die Testketten geladen, darauf folgt mindestens ein Arbeitstakt und das anschließende Auslesen der verarbeiteten Testvektoren aus den Testketten. Um die Synchronität zu wahren, sollte vorzugsweise jeweils beim Laden und Auslesen auf die längste Testkette gewartet werden. Deshalb und um durch die Parallelisierung möglichst viel zu gewinnen, werden vorzugsweise untereinander weitgehend gleich lange Testketten gebildet. Diese Anforderung ist aber nur ein Optimierungskriterium von vielen für einen schnellen Test und eine hohe Fehleraufdeckungsrate, so dass regelmäßig nicht exakt gleiche Testketten gebildet werden können.

Die Auswertungseinheit weist bevorzugt einen Speicher auf, in dem ein Satz von Testvektoren für eine geforderte Fehleraufdeckungsrate abgelegt ist. Dieser Speicher kann Teil des FPGA oder anderer Bausteine der Auswertungseinheit sein. Für die Optimierung von geeigneten Testketten und Testvektoren für eine geforderte Fehleraufdeckungsrate beispielsweise von mindestens 90%, 95%, 97% oder 99% für bestimmte Fehlerarten gibt es herkömmliche Werkzeuge, da derartige Tests im Produktionsprozess vorgesehen sind. Der Rechenaufwand ist aber enorm und wird deshalb vorzugsweise nicht zur Laufzeit, sondern vorab und auch auf mächtigeren Rechnern geleistet als der Auswertungseinheit. Prinzipiell können die Testvektoren auch zur Laufzeit generiert werden, aber es wird selten möglich sein, damit bei gleicher Testzeit eine vergleichbare Fehleraufdeckungsrate zu erreichen. Die Rechenkapazität der Auswertungseinheit wird regelmäßig nur für deutlich weniger aufwändige Optimierungen oder beispielsweise die Generierung von zufälligen Testvektoren ausreichen. Die Testvektoren können komprimiert werden, um Speicherplatz zu sparen.

Das FPGA ist bevorzugt für einen zusätzlichen Selbsttest ausgebildet. Solche Selbsttests ergänzen die Überprüfung anhand der Testketten. Ein möglicher derartiger Selbsttests ist ein Speichertest (MBIST, Memory built-in self test). Ein derartiger Speichertest ergänzt die Testketten, die vorzugsweise nur die Logik, nicht aber den Speicher erfassen.

Der Sensor ist bevorzugt als berührungslos wirkende Schutzeinrichtung ausgebildet, die einen sicheren Ausgang aufweist, wobei die Auswertungseinheit eine Schutzfeldüberwachungseinheit umfasst, um in den Überwachungsinformationen einen unzulässigen Eingriff in ein Schutzfeld innerhalb des Überwachungsbereichs zu erkennen und daraufhin ein Absicherungssignal über den sicheren Ausgang auszugeben. Der sichere Ausgang wird in der Sicherheitstechnik oft als OSSD (Output Signal Switching Device) bezeichnet. Häufig ist nicht der gesamte Überwachungsbereich eines Sensors sicherheitsrelevant, so dass darin mindestens ein Schutzfeld definiert wird, wobei Eingriffe in Bereiche außerhalb von Schutzfeldern nicht zu einer sicherheitsgerichteten Absicherung führen. Aber auch nicht jeder Eingriff in ein Schutzfeld ist automatisch ein Sicherheitsrisiko. Beispielsweise werden zu kleine Objekte oder solche Objekte ausgefiltert, die sich nicht oder nur auf einer erlaubten Bahn bewegen, und gewisse Objekte oder Objektklassen wie Paletten, Roboter oder sonstige Maschinenteile können ebenfalls als zulässig erkannt und deren Eingriffe in das Schutzfeld erlaubt werden.

Der Sensor ist bevorzugt als 3D-Kamera ausgebildet, dessen Sensorelement mindestens einen Bildsensor zur Erfassung von Bilddaten aufweist und dessen Auswertungseinheit dafür ausgebildet ist, aus den Bilddaten eine dreidimensionale Tiefenkarte zu erzeugen. 3D-Kameras erzeugen besonders große Datenmengen, und funktionale Tests sind extrem aufwändig, weil die möglichen Szenarien kaum vorhersagbar und beherrschbar sind. Die 3D-Kamera ist besonders bevorzugt als eine Stereokamera ausgebildet, deren Sensorelement mindestens zwei Bildsensoren zur Erfassung von Bilddaten aus unterschiedlichen Perspektiven und deren Auswertungseinheit eine Stereoskopieeinheit aufweist, die dafür ausgebildet ist, einander entsprechende Strukturen in den aus unterschiedlicher Perspektive aufgenommenen Bilddaten zu erkennen und aus deren Disparität eine Entfernung zu schätzen. Dieses Sensorprinzip zur Erfassung von dreidimensionalen Bilddaten ist bewährt und robust.

Die Prüfeinheit ist bevorzugt dafür ausgebildet, die Funktion des FPGA in einer Pause zwischen zwei Bildaufnahmen zu überprüfen. Dadurch ergibt sich eine klare Trennung zwischen Betriebs- und Testphasen, ohne den Betrieb durch die Fehleraufdeckung zu stören. Die Prüfung muss aber keineswegs in jeder Aufnahmepause, sondern kann je nach Sicherheitsanforderungen auch mit größeren Pausen erfolgen. Selbst wenn für maximale Sicherheit zu jedem vollen Auswertungszyklus ein Testzyklus gehören soll, bedeutet dies noch nicht, dass jede Aufnahmepause einen Testzyklus umfasst, da beispielsweise für eine redundante Schutzfeldauswertung oder Erzeugung von Distanzwerten der dreidimensionalen Bilddaten auch mehrere Bilder redundant erfasst werden können.

Das FPGA weist bevorzugt sowohl sicherheitsrelevante Logikelemente, die in den Testmodus umschaltbar sind, als auch nicht sicherheitsrelevante Logikelemente auf, die nicht in den Testmodus umschaltbar sind, wobei die Prüfeinheit dafür ausgebildet, nur die sicherheitsrelevanten Logikelemente sowie die damit verbundenen sicherheitsrelevanten kombinatorischen Schaltungen zu überprüfen. Das FPGA wird also in dieser Ausführungsform in kritische, sicherheitsrelevante und sonstige Bereiche unterteilt. Dies reduziert die Anzahl der Logikelemente, die durch Testketten geprüft werden müssen, und macht die Fehleraufdeckung gerade bei komplexen FPGAs in Quasi-Echtzeit handhabbar. Bei berührungslos wirkenden Schutzeinrichtungen zählt beispielsweise die Schutzfeldüberwachungseinheit zu den sicherheitsrelevanten Logikelementen. Bei einer 3D-Kamera gehört zu den sicherheitsrelevanten Auswertungen auch die Bestimmung der Distanzwerte, insbesondere die Stereoskopieeinheit einer Stereokamera.

Die Prüfeinheit ist bevorzugt dafür ausgebildet, die Funktion des FPGA in Zyklen kürzer als eine geforderte Ansprechzeit des Sensors zu überprüfen. Dies bedeutet für alle praktischen Belange einen Online-Funktionstest, also in Echtzeit, denn häufiger als die Ansprechzeit muss ein kritischer Ausfall nicht erkannt werden. Alternativ können auch weniger strenge Anforderungen gestellt und die Funktion weniger häufig überprüft werden. Beispielsweise kann es genügen, in größeren Abständen etwa von fünf Sekunden einen umfassenden Funktionstest des Sensors durchzuführen, der auch die erfindungsgemäße Fehleraufdeckung der Auswertungseinheit einschließt, und innerhalb der Ansprechzeit den Selbsttest auf besonders kritische Funktionen zu beschränken. Die Häufigkeit der erfindungsgemäßen Fehleraufdeckung in der Auswertungseinheit wird dann letztlich von der Anwendung und insbesondere den dafür einschlägigen Sicherheitsnormen bestimmt.

Das erfindungsgemäße Verfahren kann auf ähnliche Weise weitergebildet werden und zeigt dabei ähnliche Vorteile. Derartige vorteilhafte Merkmale sind beispielhaft, aber nicht abschließend in den sich an die unabhängigen Ansprüche anschließenden Unteransprüchen beschrieben.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine Blockdarstellung einer stereoskopischen 3D-Kamera als Beispiel eines Sensors zur Überwachung eines Überwachungsbereichs;
- Fig. 2: eine Blockdarstellung einer sicheren Auswertungseinheit für einen Sensor zur Erläuterung von Testketten;
- Fig. 3a: ein Schaltbild eines Logikelements beziehungsweise Flipflops; und
- Fig. 3b: ein Schaltbild des Logikelements gemäß Figur 3a, das um ein Multiplexelement erweitert ist, um einen Testmodus mit Ausbilden von Testketten zu unterstützen.

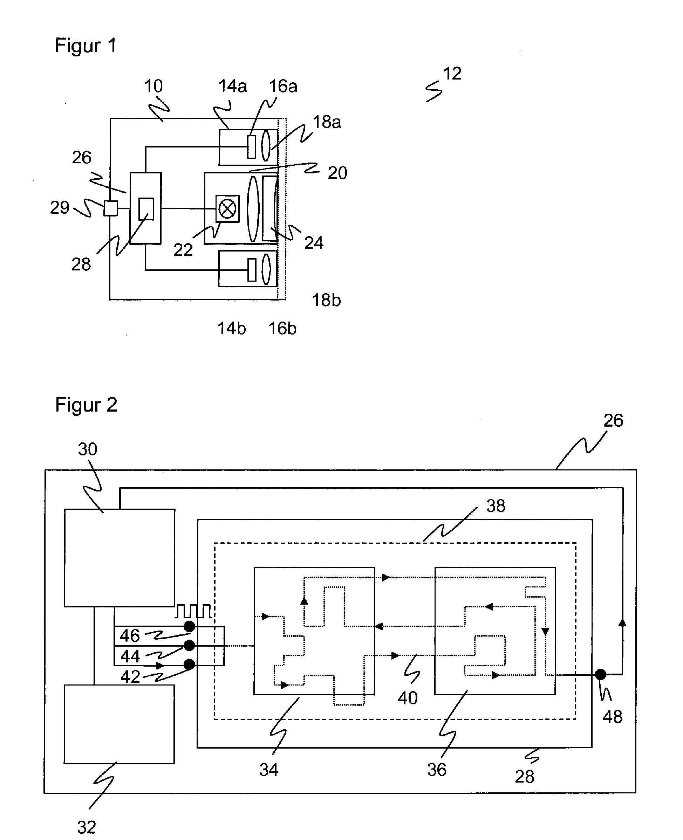

Figur 1 zeigt in einer schematischen dreidimensionalen Darstellung den allgemeinen Aufbau einer 3D-Kamera 10 nach dem Stereoskopieprinzip, die zur Überwachung eines Raum- oder Überwachungsbereichs 12 eingesetzt ist. Die Erfindung wird an dem Beispiel der 3D-Kamera 10 erläutert, umfasst aber auch andere Sensoren, wie sie beispielhaft in der Einleitung genannt sind. Mit Überwachung sind vorzugsweise sicherheitstechnische Anwendungen gemeint. Das kann die Absicherung einer gefährlichen Maschine sein, indem dreidimensionale Schutzbereiche in dem Überwachungsbereich 12 definiert werden, die von der 3D-Kamera 10 auf unzulässige Eingriffe überwacht werden. Überwachung bedeutet aber auch ganz allgemein die Informationserfassung durch einen Sensor.

In der 3D-Kamera 10 sind zwei Kameramodule 14a-b in einem bekannten festen Abstand zueinander montiert und nehmen jeweils Bilder des Überwachungsbereichs 12 auf. In jedem Kameramodul 14a-b ist jeweils ein Bildsensor 16a-b vorgesehen, üblicherweise ein matrixförmiger Aufnahmechip, der ein rechteckiges Pixelbild aufnimmt, beispielsweise ein CCD- oder ein CMOS-Sensor. Den Bildsensoren 16a-b ist jeweils ein Objektiv mit einer abbildenden Optik zugeordnet, welches als Linse 18a-b dargestellt ist und in der Praxis als jede bekannte Abbildungsoptik realisiert sein kann. In der Mitte zwischen den beiden Bildsensoren 16a-b ist eine Beleuchtungseinheit 20 dargestellt, wobei diese räumliche Anordnung nur als Beispiel zu verstehen ist und die Beleuchtungseinheit ebenso asymmetrisch oder sogar außerhalb der 3D-Kamera 10 angeordnet sein kann. Die Beleuchtungseinheit 20 umfasst eine Lichtquelle 22 und eine Sendeoptik 24, beispielsweise mit einem Mustergenerator zur Erzeugung eines strukturierten Beleuchtungsmusters in dem Raumbereich 12. Die 3D-Kamera 10 kann aber prinzipiell auch passiv sein, also keine Beleuchtungseinheit 20 aufweisen.

Mit den beiden Bildsensoren 16a-b und der Beleuchtungseinheit 20 ist eine Steuer- und Auswertungseinheit 26 verbunden, die ein FPGA 28 aufweist. Die Steuer- und Auswertungseinheit 26, die im Folgenden unter Bezugnahme auf die Figur 2 näher erläutert wird, empfängt Bilddaten der Bildsensoren 16a-b und wertet sie aus. Über einen sicheren Ausgang 29 kann die Steuer- und Auswertungseinheit einen Abschaltbefehl an eine überwachte Maschine ausgeben, wenn eine sicherheitskritische Situation erkannt wird. Die 3D-Kamera 10 kann weitere, nicht dargestellte Ein- und Ausgänge beispielsweise zur Parametrierung oder Ausgabe von Bilddaten aufweisen. Die Auswertungseinheit 26 ist als Teil der 3D-Kamera 10 dargestellt. Alternativ kann die Auswertungseinheit 26 aber auch zumindest teilweise extern der 3D-Kamera 10 vorgesehen sein, beispielsweise innerhalb einer übergeordneten Steuerung oder Sicherheitssteuerung implementiert oder dort als Steckkarte eingefügt sein. Somit wird die Auswertungseinheit 26 unabhängig von ihrer Positionierung und Implementierung als Teil des Sensors aufgefasst.

Figur 2 zeigt eine Blockdarstellung der Steuer- und Auswertungseinheit 26. Das FPGA 28 ist besonders geeignet, große Datenmengen mit vergleichsweise einfachen Rechenschritten zu verarbeiten. Die Steuer- und Auswertungseinheit 26 kann abweichend von der Darstellung insgesamt nur aus dem FPGA 28 bestehen, oder sie weist zusätzliche Bausteine wie Speicherbereiche, PLDs (programmable logic device), DPSs (Digital Signal Processor), ASICs (Application Specific Integrated Circuit), Mikroprozessoren oder andere Digitalbausteine und gegebenenfalls auch analoge Schaltungsteile auf. Nicht dargestellt sind weitere denkbare Elemente wie Spannungs- oder Temperatursensoren.

Als funktionale Blöcke, gleich in welcher Hardware, sind in der Steuer- und Auswertungseinheit 26 eine Prüfeinheit 30 zum Testen des FPGA 28 sowie ein Speicher 32 mit Testvektoren vorgesehen. Die Prüfeinheit 30 ist rein beispielhaft neben dem FPGA 28 und damit als Teil eines weiteren Bausteins der Auswertungseinheit 26 dargestellt, etwa einem zweiten FPGA. Die Prüfeinheit 30 kann alternativ zumindest teilweise auf dem FPGA 28 implementiert sein. Auf dem FPGA 28 erfolgt wenigstens partiell Auswertung von Sensordaten. Im hier betrachteten Beispiel einer sicherheitstechnisch eingesetzten stereoskopischen 3D-Kamera 10 umfasst das FPGA 28 insbesondere eine Stereoskopieeinheit 34 und eine Schutzfeldüberwachungseinheit 36. Die Stereoskopieeinheit 34 berechnet aus den Bilddaten der Bildsensoren 16a-b mit Hilfe einer stereoskopischen Disparitätsschätzung dreidimensionale Bilddaten des Überwachungsbereichs 12. Die Schutzfeldüberwachungseinheit 36 erkennt in den dreidimensionalen Bilddaten unzulässige Eingriffe in definierte Schutzbereiche innerhalb des Überwachungsbereichs 12 und gibt gegebenenfalls über den sicheren Ausgang 29 ein sicherheitsgerichtetes Abschaltsignal an eine überwachte Maschine aus.

Die Funktion der Stereoskopieeinheit 34 und der Schutzfeldüberwachungseinheit 36 zählt zu einem sicherheitskritischen oder sicherheitsrelevanten Bereich 38 des FPGA 28, das zusätzlich auch andere, nicht sicherheitsrelevante Funktionen erfüllen kann. Dabei hat das dargestellte Größenverhältnis des sicherheitsrelevanten Bereichs 38 gegenüber dem FPGA 28 keine Bedeutung, vielmehr ist das Verhältnis von sicherheitsrelevanten zu nicht sicherheitsrelevanten Funktionen auf dem FPGA 28 prinzipiell beliebig. Für den Fall, dass die Prüfeinheit 30 zumindest teilweise auf dem FPGA 28 implementiert ist, kann sie wiederum zumindest teilweise zu dem sicherheitsrelevanten Bereich 38 zählen oder nicht.

Um eine zuverlässige Auswertung und damit eine zuverlässige Überwachungsfunktion der 3D-Kamera 10 zu gewährleisten, wird das FPGA 28 von der Prüfeinheit 30 im Betrieb getestet, um etwaige Fehler aufzudecken, wie beispielsweise Stuck-At-Fehler im Sinne eines logischen Fehlermodells. Die Prüfung umfasst nur den sicherheitsrelevanten Bereich 38 oder das gesamte FPGA 28 und erfolgt häufig genug, damit ein Hardwareausfall in dem FPGA 28 die Sicherheit nicht beeinträchtigen kann. Das kann beispielsweise jeweils einen Test pro durch die gewünschte Ansprechzeit der 3D-Kamera 10 gegebenem Zyklus bedeuten, insbesondere in einer Aufnahmepause zwischen der Erfassung zweier Bilder durch die Bildsensoren 16a-b.

Für den Test schaltet die Prüfeinheit 30 Logikelemente des FPGA 28 in einen Testmodus um, in dem die Logikelemente zu einer Testkette 40 verbunden sind. Diese Testkette 40 weist drei Eingänge auf, nämlich einen Testmustereingang 42, einen Testmoduseingang 44, einen Testtakteingang 46 und einen Testmusterausgang 48.

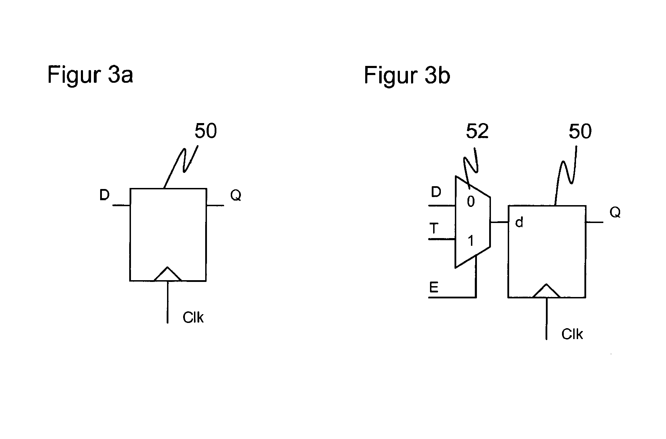

Für eine genauere Erläuterung des Tests zeigt die Figur 3a ein einzelnes Logikelement 50 in Form eines Flipflops mit einem Eingang D, einem Ausgang Q und einem Takteingang Clk. Das Logikelement nimmt je nach Eingang D einen Logikzustand Null oder Eins an und erzeugt einen entsprechenden Ausgang Q. Um Teil der Testkette 40 werden zu können, wird das Logikelement 50 wie in Figur 3b illustriert um ein Element erweitert, welches wahlweise zwischen dem Testmodus und dem üblichen Logikbetrieb des Logikelements 50 umschaltet. Dieses Element ist in Figur 3b ein Multiplexelement 52, welches das Logikelement 50 abhängig von der Wahl am Eingang E im Testmodus mit einem Testeingang T und im üblichen Logikbetrieb außerhalb des Testmodus' mit dem Eingang D verbindet. In diesem üblichen Logikbetrieb ist also das Logikelement 50 mit sogenannten kombinatorischen Schaltungsteilen des FPGA 28 verbunden, die selbst nicht Teil der Testkette 40 sind, aber über die Testkette 40 geprüft werden können.

Zurück zu Figur 2, ermöglicht der Testmoduseingang 44, wahlweise die zu testenden Logikelemente 50 mit Hilfe des Multiplexelements 52 zu der Testkette 40 oder in ihrem üblichen Logikfluss zu verbinden. In der Testkette 40 sind die Logikelemente seriell zu einem Schieberegister verbunden. Mit einem an dem Testeingang 44 angelegten Takt werden auf den Testmustereingang 42 angelegte Bits schrittweise in die Testkette 40 geladen und entsprechend schrittweise an dem Testmusterausgang 48 ausgetaktet.

Damit kann die Prüfeinheit 30 zyklisch im Betrieb auf den Testmodus umschalten und die Funktion des FPGA 28 wie folgt testen:
In einem ersten Schritt wird mittels des Testmoduseingangs 44 die Testkette 40 verbunden. Ein Testvektor wird aus dem Speicher 32 gelesen und bitweise in das von der Testkette 40 gebildete Schieberegister geladen. Nach einer Anzahl von n Takten an dem Testtakteingang 46, die sowohl der Länge der Testkette 40 als auch der Bitzahl des Testvektors entspricht, sind alle an der Testkette 40 beteiligten Logikelemente 50 in einem von dem Testvektor definierten Zustand.

In einem zweiten Schritt wird mittels des Testmoduseingangs 44 die Testkette 40 wieder aufgelöst. In dem FPGA 28 besteht somit die für den Betrieb vorgesehene Logikkonfiguration, in welcher der Logikfluss unter realen Bedingungen getestet werden kann. Über die Testkette 40 sind auch dazwischen liegende und zu testende kombinatorische Schaltungsteile des FPGA 28 in einen definierten Zustand gebracht. Nun wird mindestens ein Arbeitstakt des FPGA 28 ausgeführt, in dem der Testvektor gemäß dem für den Betrieb vorgesehenen Logikfluss in den kombinatorischen Schaltungsteilen verarbeitet wird. Nach diesem Arbeitstakt sind entsprechend der Logik der kombinatorischen Schaltungsteile die Zustände in den Logikelementen 50 der Testkette 40 verändert.

In einem dritten Schritt wird die Testkette 40 erneut mittels des Testmoduseingangs 44 verbunden und der verarbeitete Testvektor in einer Anzahl von n Takten an dem Testtakteingang 46 bitweise an dem Testmusterausgang 48 ausgelesen. Ein Vergleich mit einem ebenfalls in dem Speicher 32 abgelegten erwarteten verarbeiteten Testvektor deckt auf, wenn eines der in der Testkette 40 beteiligten Logikelemente 50 oder ein dazwischen liegender und über die Testkette 40 in dem Arbeitstakt geprüfter kombinatorischer Schaltungsteil einen Fehler aufweist. Die genaue Nichtübereinstimmung lässt möglicherweise auch eine Diagnose, also Schlüsse auf die Art und Position des Fehlers zu, aber gewöhnlich reicht es, Fehler an sich aufzudecken beziehungsweise auszuschließen.

Ein einziger Testvektor kann nur bestimmte Fehlerfälle überprüfen, so dass für eine höhere Fehleraufdeckungsrate der beschriebene Test mit anderen Testvektoren wiederholt werden kann. Das Auffinden geeigneter Testketten 40 zur Definition der Logik des FPGA 28 einschließlich des Testmodus' auf Hochsprachenebene (z. B. VHDL) beziehungsweise Netzlistenebene sowie das automatische Erzeugen von Testvektoren (ATPG, Automated Test Pattern Generation), die in dem Speicher 32 abgelegt werden, ist eine hochkomplexe Optimierungsaufgabe, für die aber Werkzeuge existieren, die für den Produktionsprozess entwickelt wurden.

Um eine Testkette zu prüfen, sind n+1+n Takte für Laden, Arbeitstakt und Auslesen des Testvektors erforderlich. Die Testgeschwindigkeit lässt sich praktisch verdoppeln, indem der erste Schritt und der dritte Schritt simultan erfolgen, d. h. gleichzeitig ein neuer Testvektor in die Testkette 40 geladen und der zuvor verarbeitete Testvektor aus der Testkette 40 gelesen wird. Eine weitere Möglichkeit der Beschleunigung besteht in der Parallelisierung durch mehrere Testketten 40. Mit entsprechendem Load Balancing, also zumindest in etwa gleich langen Testketten 40, kann nahezu eine Verkürzung um einen Faktor erreicht werden, welcher der Anzahl der Testketten 40 entspricht.

Eine wichtige Fehlerart sind Stuck-at-Fehler. Für die Berechnungen in der Stereoskopieeinheit 34 und der Schutzfeldauswertungseinheit 36 besteht ein Bedarf an ca. 10.000 Logikelementen 50. Eine Fehlerabdeckung von 60% ist beispielsweise mit sieben, eine Fehlerabdeckung zu 90% mit 48 Testmustern oder Testvektoren erreichbar. Diese Anzahl von Tests ist innerhalb von typischen Ansprechzeiten eines Sensors von beispielsweise 20 ms leistbar.

Die beschriebene Fehleraufdeckung anhand von Testketten 40 kann durch den Zugang zu weiterer bereits in dem FPGA 28 implementierter Hardware wie MBIST zum Testen des Speichers oder ECC (Error correction Codes) sowie Nutzung von bereits vorhandenen Standardschaltungsteilen und Logikschaltungen noch verbessert werden. Für die Überprüfung von diesen bereits implementierten Funktionen wie beispielsweise ECC ist es notwendig, diese gezielt in den Fehlerfall steuern zu können (faultinjection).

## Patentansprüche

1. Sensor (10), insbesondere optoelektronischer Sensor, zur Überwachung eines Überwachungsbereichs (12), mit einem Sensorelement (16) zur Erfassung von Überwachungsinformationen aus dem Überwachungsbereich (12) und mit einer sicheren Auswertungseinheit (26) zur Auswertung der Überwachungsinformationen, die ein FPGA (28) und eine Prüfeinheit (30) aufweist, um die eigene Funktion zu überprüfen,
**dadurch gekennzeichnet,**
**dass** Logikelemente (50) des FPGA (28) in einen Testmodus umschaltbar sind, in dem die Logikelemente (50) zu mindestens einer Testkette (40) verbunden sind, und dass die Prüfeinheit (30) dafür ausgebildet ist, die Funktion des FPGA (28) während des Betriebs durch Umschalten auf den Testmodus mit Hilfe der mindestens einen Testkette (40) zu überprüfen.

2. Sensor (10) nach Anspruch 1,
wobei die Logikelemente (50) in der Testkette (40) ein Schieberegister bilden, in dem auf einen Takt hin ein Logikelement (50) seinen Logikzustand an seinen Nachfolger in der Testkette (40) weitergibt.

3. Sensor (10) nach Anspruch 1 oder 2,
wobei die Testkette (40) einen Testmustereingang (42) für die Eingabe eines Logikzustands an das erste Element (50) der Testkette (40), einen Testmusterausgang (48) für die Ausgabe eines Logikzustands von dem letzten Element (50) der Testkette (40), einen Testtakteingang (46) sowie einen Testmoduseingang (44) zum Umschalten zwischen Testmodus und eigentlichem Betrieb aufweist.

4. Sensor (10) nach einem der vorhergehenden Ansprüche,
wobei die Logikelemente (50) ein Multiplexelement (52) aufweisen, das im Testmodus den Eingang (D, T) des Logikelements (50) mit dem Vorgänger (50) in der Testkette (40) verbindet.

5. Sensor (10) nach einem der vorhergehenden Ansprüche,
wobei die Prüfeinheit (30) dafür ausgebildet ist, für eine Überprüfung der Funktion in einem ersten Schritt die Logikelemente (50) in den Testmodus umzuschalten, dadurch zu der mindestens einen Testkette (40) zu verbinden und einen Testvektor in die Testkette (40) zu laden, in einem zweiten Schritt den Testmodus auszuschalten und mindestens einen Arbeitstakt des FPGA (28) auszuführen, und in einem dritten Schritt die Logikelemente (50) nochmals in den Testmodus umzuschalten und den durch den mindestens einen Arbeitstakt veränderten Testvektor aus der Testkette (40) zu lesen.

6. Sensor (10) nach Anspruch 5,
wobei die Prüfeinheit (30) dafür ausgebildet ist, während des Lesens des veränderten Testvektors bereits einen neuen Testvektor in die Testkette (40) zu laden.

7. Sensor (10) nach einem der vorhergehenden Ansprüche,
wobei die Logikelemente (50) in dem Testmodus zu mehreren Testketten (40) verbunden sind und die Prüfeinheit (30) dafür ausgebildet ist, die mehreren Testketten (40) parallel zu überprüfen.

8. Sensor (10) nach einem der vorhergehenden Ansprüche,
wobei die Auswertungseinheit (26) einen Speicher (32) aufweist, in dem ein Satz von Testvektoren für eine geforderte Fehleraufdeckungsrate abgelegt ist.

9. Sensor (10) nach einem der vorhergehenden Ansprüche,
wobei das FPGA (28) für einen zusätzlichen Selbsttest ausgebildet ist.

10. Sensor (10) nach einem der vorhergehenden Ansprüche,
wobei der Sensor (10) als berührungslos wirkende Schutzeinrichtung ausgebildet ist, die einen sicheren Ausgang (29) aufweist, wobei die Auswertungseinheit (26) eine Schutzfeldüberwachungseinheit (36) umfasst, um in den Überwachungsinformationen einen unzulässigen Eingriff in ein Schutzfeld innerhalb des Überwachungsbereichs (12) zu erkennen und daraufhin ein Absicherungssignal über den sicheren Ausgang (29) auszugeben.

11. Sensor (10) nach einem der vorhergehenden Ansprüche,
der als 3D-Kamera (10) ausgebildet ist, dessen Sensorelement mindestens einen Bildsensor (16) zur Erfassung von Bilddaten aufweist und dessen Auswertungseinheit (26) dafür ausgebildet ist, aus den Bilddaten eine dreidimensionale Tiefenkarte zu erzeugen, wobei die 3D-Kamera (10) insbesondere eine Stereokamera ist, deren Sensorelement mindestens zwei Bildsensoren (16a-b) zur Erfassung von Bilddaten aus unterschiedlichen Perspektiven und deren Auswertungseinheit (26) eine Stereoskopieeinheit (34) aufweist, die dafür ausgebildet ist, einander entsprechende Strukturen in den aus unterschiedlicher Perspektive aufgenommenen Bilddaten zu erkennen und aus deren Disparität eine Entfernung zu schätzen.

12. Sensor (10) nach Anspruch 11,
wobei die Prüfeinheit (30) dafür ausgebildet ist, die Funktion des FPGA (28) in einer Pause zwischen zwei Bildaufnahmen zu überprüfen.

13. Sensor (10) nach einem der vorhergehenden Ansprüche,
wobei das FPGA (28) sowohl sicherheitsrelevante Logikelemente (38, 50), die in den Testmodus umschaltbar sind, als auch nicht sicherheitsrelevante Logikelemente (50) aufweist, die nicht in den Testmodus umschaltbar sind, und wobei die Prüfeinheit dafür ausgebildet, nur die sicherheitsrelevanten Logikelemente (38, 50) sowie die damit verbundenen sicherheitsrelevanten kombinatorischen Schaltungen zu überprüfen.

14. Sensor (10) nach einem der vorhergehenden Ansprüche,
wobei die Prüfeinheit (30) dafür ausgebildet ist, die Funktion des FPGA (28) in Zyklen kürzer als eine geforderte Ansprechzeit des Sensors (10) zu überprüfen.

15. Verfahren zur Fehleraufdeckung in einer Auswertungseinheit (26), die ihre eigene Funktion überprüft, um eine sichere Auswertung zu gewährleisten, wobei die Auswertungseinheit (26) ein FPGA (28) aufweist und von einem Sensorelement (16) erfasste Überwachungsinformationen aus einem Überwachungsbereich (12) auswertet,
**dadurch gekennzeichnet,**
**dass** zur Fehleraufdeckung während des Betriebs in einen Testmodus umgeschaltet wird, in dem Logikelemente (50) des FPGA (28) zu mindestens einer Testkette (40) verbunden sind, und in dem Testmodus die Funktion des FPGA (28) mit Hilfe der mindestens einen Testkette (40) geprüft wird.

## Claims

1. A sensor (10), in particular an optoelectronic sensor, for monitoring a monitored zone (12), having a sensor element (16) for detecting monitoring information from the monitored zone (12) and having a safe evaluation unit (26) for evaluating the monitoring information which has an FPGA (28) and a test unit (30) to test its own function,
**characterised in that**
the logic element (50) of the FPGA (28) can be switched over into a test mode in which the logic elements (50) are connected to at least one test chain (40); and **in that** the test unit (30) is configured to check the function of the FPGA (28) during the operation by switching over to the test mode with the aid of the at least one test chain (40).

2. A sensor (10) in accordance with claim 1,
wherein the logic elements (50) in the test chain (40) form a shift register in which a logic element (50) passes on its logic state to its successor in the test chain (40) in response to a clock pulse.

3. A sensor (10) in accordance with claim 1 or claim 2,
wherein the test chain (40) has a test pattern input (42) for the input of a logic state to the first element (50) of the test chain (40), a test pattern output (48) for the output of a logic state from the last element (50) of the test chain (40), a test clock pulse input (46) and a test mode input (44) for switching over between the test mode and the actual operation.

4. A sensor (10) in accordance with any one of the preceding claims,
wherein the logic elements (50) have a multiplex element (52) which connects the input (D, T) of the logic element (50) to the predecessor (50) in the test chain (40) in the test mode.

5. A sensor (10) in accordance with any one of the preceding claims,
wherein the test unit (30) is configured to switch over the logic elements (50) into the test mode for a check of the function in a first step, thereby to connect them to the at least one test chain (40) and to load a test vector into the test chain (40), to switch off the test mode in a second step and to carry out at least one work cycle of the FPGA (28) and to switch over the logic elements (50) into the test mode again in a third step and to read the test vector changed by the at least one work cycle from the test chain (40).

6. A sensor (10) in accordance with claim 5,
wherein the test unit (30) is configured already to load a new test vector into the test chain (40) during the reading of the changed test vector.

7. A sensor (10) in accordance with any one of the preceding claims,
wherein the logic elements (50) are connected to a plurality of test chains (40) in the test mode and the test unit (30) is configured to test the plurality of test chains (40) in parallel.

8. A sensor (10) in accordance with any one of the preceding claims,
wherein the evaluation unit (26) has a memory (32) in which a set of test vectors for a required error discovery rate is stored.

9. A sensor (10) in accordance with any one of the preceding claims,
wherein the FPGA (28) is configured for an additional self-test.

10. A sensor (10) in accordance with any one of the preceding claims,
wherein the sensor (10) is configured as a contactlessly acting protective device which has a safe output (29), wherein the evaluation unit (26) comprises a protected field monitoring unit (36) to recognize an unauthorized intrusion into a protected field within the monitored zone (12) in the monitoring information and thereupon to output a securing signal via the safe output (29).

11. A sensor (10) in accordance with any one of the preceding claims,
which is configured as a 3D camera (10) whose sensor element has at least one image sensor (16) for detecting image data and whose evaluation unit (26) is configured to generate a three-dimensional depth map from the image data, wherein the 3D camera (10) is in particular a stereo camera whose sensor element has at least two image sensors (16a-b) for detecting image data from different perspectives and whose evaluation unit (26) has a stereoscopy unit (34) which is configured to recognize mutually corresponding structures in the image data taken from different perspectives and to estimate a distance from their disparity.

12. A sensor (10) in accordance with claim 11,
wherein the test unit (30) is configured to check the function of the FPGA (28) in a pause between the taking of two images.

13. A sensor (10) in accordance with any one of the preceding claims,
wherein the FPGA (28) has both safety-relevant logic elements (38, 50) which can be switched over into the test mode and non-safety relevant logic elements (50) which cannot be switched over into the test mode, and wherein the test unit is configured only to check the safety-relevant logic elements (38, 50) and the safety-relevant combinatory circuits connected thereto.

14. A sensor (10) in accordance with any one of the preceding claims,
wherein the test unit (30) is configured to check the function of the FPGA (28) in cycles shorter than a required response time of the sensor (10).

15. A method of error discovery in an evaluation unit (26) which tests its own function to ensure a safe evaluation, wherein the evaluation unit (26) has an FPGA (28) and evaluates monitoring information from a monitored zone (12) detected by a sensor element (16),
**characterised in that**
a switchover is made into a test mode for error discovery during operation, in which test mode logic elements (50) of the FPGA (28) are connected to at least one test chain (40) and the function of the FPGA (28) is tested with the aid of the at least one test chain (40) in the test mode.

## Revendications

1. Capteur (10), en particulier capteur optoélectronique, pour la surveillance d'une zone de surveillance (12), comprenant un élément capteur (16) pour saisir des informations de surveillance provenant de la zone de surveillance (12) et comprenant une unité d'évaluation sécurisée (26) pour l'évaluation des informations de surveillance, laquelle comprend un FPGA (24) et une unité de contrôle (30) afin de contrôler le propre fonctionnement,
**caractérisé en ce que**
des éléments logiques (50) du FPGA (28) peuvent être commutés vers un mode de test dans lequel les éléments logiques (50) sont reliés pour former au moins une chaîne de test (40), et
**en ce que** l'unité de contrôle (30) est réalisée pour contrôler la fonction du FPGA (28) pendant le service par commutation vers le mode de test à l'aide de ladite au moins une chaîne de test (40).

2. Capteur (10) selon la revendication 1,
dans lequel les éléments logiques (50) dans la chaîne de test (40) forment un registre à décalage dans lequel un élément logique (50) transmet sur une cadence son état logique à son successeur dans la chaîne de test (40).

3. Capteur (10) selon la revendication 1 ou 2,
dans lequel la chaîne de test (40) comprend une entrée de modèle de test (42) pour l'injection d'un état logique au premier élément (50) de la chaîne de test (40), une sortie de modèle de test (48) pour la sortie d'un état logique du dernier élément (50) de la chaîne de test (40), une entrée de cadence test (46) ainsi qu'une entrée de mode de test (44) pour la commutation entre le mode de test et le service proprement dit.

4. Capteur (10) selon l'une des revendications précédentes,
dans lequel les éléments logiques (50) comprennent un élément multiplexeur (52) qui, dans le mode de test, relie l'entrée (D, T) de l'élément logique (50) au prédécesseur (50) dans la chaîne de test (40).

5. Capteur (10) selon l'une des revendications précédentes,
dans lequel, pour un contrôle du fonctionnement, l'unité de contrôle (30) est réalisée en vue de, dans une première étape, commuter des éléments logiques (50) vers le mode de test et ainsi les relier à ladite au moins une chaîne de test (40), et charger un vecteur de test dans la chaîne de test (40), dans une seconde étape, couper le mode de test et exécuter au moins une cadence de travail du FPGA (28), et dans une troisième étape, commuter les éléments logiques (50) une nouvelle fois vers le mode de test et lire depuis la chaîne de test (40) le vecteur de test modifié par ladite au moins une cadence de travail.

6. Capteur (10) selon la revendication 5,
dans lequel l'unité de contrôle (30) est réalisée pour, pendant la lecture du vecteur de test modifié, charger déjà un nouveau vecteur de test dans la chaîne de test (40).

7. Capteur (10) selon l'une des revendications précédentes,
dans lequel les éléments logiques (50) sont reliés dans le mode de test à plusieurs chaînes de test (40) et l'unité de contrôle (30) est réalisée pour contrôler en parallèle lesdites plusieurs chaînes de test (40).

8. Capteur (10) selon l'une des revendications précédentes,
dans lequel l'unité d'évaluation (26) comprend une mémoire dans laquelle est mémorisé un jeu de vecteurs de test pour un taux requis de découverte d'erreurs.

9. Capteur (10) selon l'une des revendications précédentes,
dans lequel le FPGA (28) est réalisé pour un autotest additionnel.

10. Capteur (10) selon l'une des revendications précédentes,
dans lequel le capteur (10) est réalisé sous forme d'un système de protection à action sans contact, qui comporte une sortie sécurisée (29), dans lequel l'unité d'évaluation (26) inclut une unité de surveillance de champ de protection (36) afin de reconnaître dans les informations de surveillance une intervention inadmissible dans un champ de protection à l'intérieur de la zone de surveillance (12) et délivrer ensuite un signal de sécurisation via la sortie sécurisée (29).

11. Capteur (10) selon l'une des revendications précédentes,
qui est réalisé sous forme de caméra 3D (10), dont l'élément capteur comprend au moins un capteur d'image (16) pour la détection de données image, et dont l'unité d'évaluation (26) est réalisée pour engendrer à partir des données image une carte de profondeur tridimensionnelle, dans lequel la caméra 3D (10) est en particulier une caméra stéréoscopique dont l'élément capteur comprend au moins deux capteurs d'image (16a-b) pour la détection de données image depuis différentes perspectives et dont l'unité d'évaluation (26) comprend une unité stéréoscopique (34) qui est réalisée pour reconnaître des structures mutuellement correspondantes dans les données image prises depuis différentes perspectives et pour estimer un éloignement à partir de leur disparité.

12. Capteur (10) selon la revendication 11,
dans lequel l'unité de contrôle (30) est réalisée pour contrôler le fonctionnement du FPGA (28) dans une pause entre deux prises d'images.

13. Capteur (10) selon l'une des revendications précédentes,
dans lequel le FPGA (28) comprend à la fois des éléments logiques déterminants pour la sécurité (38, 50), qui peuvent être commutés vers le mode de test, et des éléments logiques non déterminants pour la sécurité (50), qui ne peuvent pas être commutés vers le mode de test, et dans lequel l'unité de contrôle est réalisée pour contrôler uniquement les éléments logiques déterminants pour la sécurité (38, 50) ainsi que les circuits combinatoires déterminants pour la sécurité qui sont reliés à ceux-ci.

14. Capteur (10) selon l'une des revendications précédentes,
dans lequel l'unité de contrôle (30) est réalisée pour contrôler le fonctionnement du FPGA (28) dans des cycles plus courts qu'un temps de réaction requis du capteur (10).

15. Procédé pour la découverte d'erreurs dans une unité d'évaluation (26) qui contrôle son propre fonctionnement, afin de garantir une évaluation sécurisée, dans lequel l'unité d'évaluation (26) comprend un FPGA (28) et évalue des informations de surveillance détectées par un élément capteur (16) en provenance d'une zone de surveillance (12),
**caractérisé en ce que**, pour la découverte d'erreurs pendant le service, on effectue une commutation vers un mode de test dans lequel des éléments logiques (50) du FPGA (28) sont reliés pour former au moins une chaîne de test (40) et on contrôle dans le mode de test la fonction du FPGA (28) à l'aide de ladite au moins une chaîne de test (40).
